# EUROPEAN PATENT APPLICATION

(11) **EP 2 410 561 A1**
(43) Date of publication of application: **25.01.2012**
(21) Application number: 09841806.4
(22) Date of filing: 26.11.2009
(51) Int. Cl.: H01L 23/28, H01L 21/56, H01L 25/04, H01L 25/18

(54) **CIRCUIT MODULE AND ELECTRONIC DEVICE**

(30) Priority: 19.03.2009 JP 2009068022
(71) Applicant: Panasonic Corporation, Kadoma-shi Osaka 571-8501 (JP)
(72) Inventor: INOUE, Katsuhiro, Osaka 540-6207 (JP)
(74) Representative: Grünecker, Kinkeldey, Stockmair & Schwanhäusser
(86) International application number: PCT/JP2009/006408
(87) International publication number: WO 2010/106599

(57) **Abstract**

A circuit module capable of individually shielding electronic components and also responding to thinned requirement is provided.

A circuit module 10 includes a circuit board 11, two electronic components 16A, 16B mounted on the circuit board 11, a molding resin layer 12 for sealing the circuit board 11 and the electronic components 16A, 16B, and a conductive resin layer 13 formed of a conductive resin on the molding resin layer 12. A slit S which penetrates the molding resin layer 12 and reaches the circuit board 11 is formed between the two electronic components 16A, 16B, and the conductive resin is filled inside the slit S.

## Description

### Technical Field

The present invention relates to a circuit module which can electromagnetically shield electronic components to one another and also can be thinned.

### Background Art

Conventionally, a small electronic component made by mounting plural element components on a substrate has become widespread rapidly. As this kind of electronic component, for example, there are a sealed or molded component such as an IC or a hybrid module, a component covered with a metallic cap, a component housed in a metallic cap, etc.

For example, a circuit module housed in the metallic cap has to be provided with a shielding effect in the case of being molded with a molding resin, and it is essential to take shielding measures. Consequently, in order to provide the shielding effect on the electronic component mounted on the substrate, there is proposed a method for manufacturing a circuit module in which an electronic component of a circuit board is covered and sealed with a conductive resin, or the like (for example, see Patent Document 1).

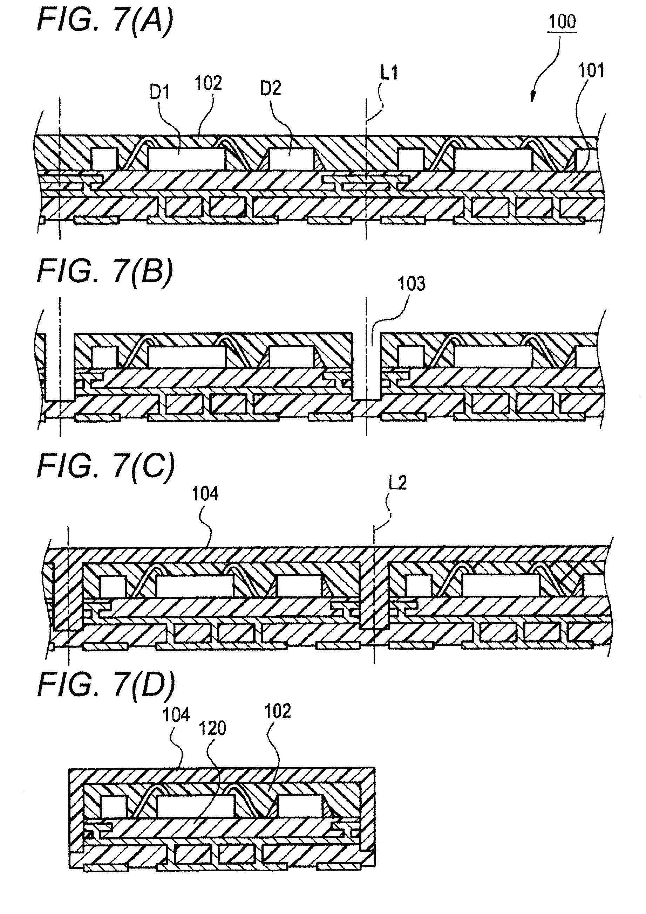

In a circuit module 100 shown in Fig. 7(D), at first, a sealing resin layer 102 is formed on an upper surface side of an aggregate board 101 on which element components D1, D2 are mounted as shown in Fig. 7(A). Thereafter, as shown in Fig. 7(B), a groove 103 ranging from an upper surface direction of the aggregate board 101 to the aggregate board 101 is formed by half cutting along a separation line L1. Next, as shown in Fig. 7(C), a conductive resin is poured so as to bury the groove 103 and a shielding layer 104 is formed on the sealing resin layer 102. Finally, as shown in Fig. 7(D), cutting is performed along a cutting line L2 with a cut width narrower than a cut width by the half cutting, and an end face of the shielding layer 104 and a cut board 120 are processed in the same cut planar shape. Consequently, a side surface of the sealing resin layer 102 and a half-cut surface of the aggregate board 101 are covered with the conductive resin forming the shielding layer 104, so that a high shielding effect can be obtained.

### Related Art Documents

### Patent Documents

Patent Document 1: JP-A-2008-288610

### Summary of the Invention

### Problem to be Solved by the Invention

However, in the circuit module described above, individual electromagnetic shielding (undesirable radiation) or electrostatic shielding measures for each electronic component (element components D1, D2) are not particularly considered as a problem. Because of such circumstances, development of means capable of blocking electromagnetic waves or static electricity for individual electronic component is variously considered, but particularly effective means is not found. This is because, for example, various wirings (a ground line, a power line, a signal line, etc.) etc. in a circuit board formed in the vicinity of the electronic components become an obstacle, and it becomes difficult to form shielding means.

Further, development of the shielding means capable of being thinned in association with thinning of the circuit module is also desired recently.

In view of the circumstances described above, an object of the invention is to provide a circuit module capable of individually shielding electronic components and also responding to the thinning requirement.

### Means for Solving the Problem

A circuit module of the invention is a circuit module including: a circuit board having a first surface and a second surface opposite to the first surface; two or more electronic components mounted on the first surface; a molding resin layer which seals the first surface and the electronic components; and a conductive resin layer formed by a conductive resin on the molding resin layer, wherein a slit penetrating the molding resin layer and reaching the first surface is formed between the two electronic components, and the conductive resin is filled inside the slit.

With this configuration, the electronic components can be individually shielded by the molding resin layer formed inside the slit between the two electronic components. Also, since it becomes unnecessary to be covered with a metallic frame or cap as in the related art, it is possible to respond to the thinning requirement.

As one aspect of the invention, the circuit module includes a first signal line which connects the two electronic components, and the first signal line is arranged between the slit and the second surface and is arranged with an insulating material sandwiched between the slit and the first signal line.

Generally, in the slit formed in the circuit board using a blade etc., since accuracy of dicing is low and the circuit board itself is thin, a depth of the formed slit may become deeper than a predetermined depth. In this aspect, the signal line extending between two blocks provided with the electronic components is formed in a deeper portion of the circuit board. Therefore, even when variations in the slit depth occur at the time of dicing, dicing work can be adequately performed.

As one aspect of the invention, the circuit module described above includes: a second signal line arranged in the circuit board closer to the first surface than the first signal line, and an end face of the second signal line opposes the slit with an insulating material sandwiched between the slit and the end face.

With this configuration, the signal line which does not extend between the blocks of different electronic components can be formed in a shallow place. Further, even when variations in the slit depth occur at the time of dicing by the depth of the second signal line, the present circuit module can be manufactured. Consequently, accuracy at the time of dicing is not required excessively, so that the dicing can be performed at low cost, and the circuit module itself can also be manufactured at low cost.

As one aspect of the invention, in the circuit module described above, the slit includes two outer edge slits formed in two outer sides of the circuit module, and two inner slits formed inside the circuit module in plan view, and closed space surrounded by the conductive resin layer is formed by the two outer edge slits and the two inner slits filled with the conductive resin.

With this configuration, shielding properties of the electronic component inside the closed space can be improved.

Also, as one aspect of the invention, in the circuit module described above, the inner slit is formed so as to penetrate a ground line provided on a surface of the circuit board for mounting the electronic component.

With this configuration, even when static electricity is generated, the static electricity can be transferred from the ground line to the other outside, and a static electromagnetic shielding effect can be ensured.

Also, an electronic device of the invention includes any one of the circuit modules described above.

Consequently, the electronic device including the circuit module capable of individually shielding the mounted electronic components and also responding to the thinning requirement can be provided.

### Advantages of the Invention

In the circuit module of the invention, the slit which penetrates the molding resin and reaches the circuit board is formed between the two electronic components, and the conductive resin is filled inside the slit, so that the electronic components can be individually shielded. Also, the circuit module of the invention has an advantage capable of responding to the thinning requirement since a shielding layer thinner than a metal plate is used as shielding means and it becomes unnecessary to be covered with a conventional metallic frame or cap.

### Brief Description of the Drawings

Fig. 1(A) is a schematic plan view showing a circuit module according to a first embodiment of the invention, and Fig. 1 (B) is a sectional view taken on line IB-IB in Fig. 1(A).
Fig. 2 is a process diagram showing a manufacturing method of the circuit module shown in Fig. 1.
Fig. 3 is a schematic plan view showing a first modified example of the circuit module shown in Fig. 1.
Fig. 4 is a schematic plan view showing a second modified example of the circuit module shown in Fig. 1.
Fig. 5(A) is a schematic plan view showing a circuit module according to a second embodiment of the invention, and Fig. 5(B) is a sectional view taken on line VB-VB in Fig. 5(A).
Fig. 6 is a schematic plan view showing a modified example of the circuit module shown in Fig. 5.
Fig. 7 is a process diagram showing a manufacturing method of a conventional circuit module.

### Mode for Carrying Out the invention

Hereinafter, embodiments of the invention will be described in detail with reference to the accompanying drawings.

### (First embodiment)

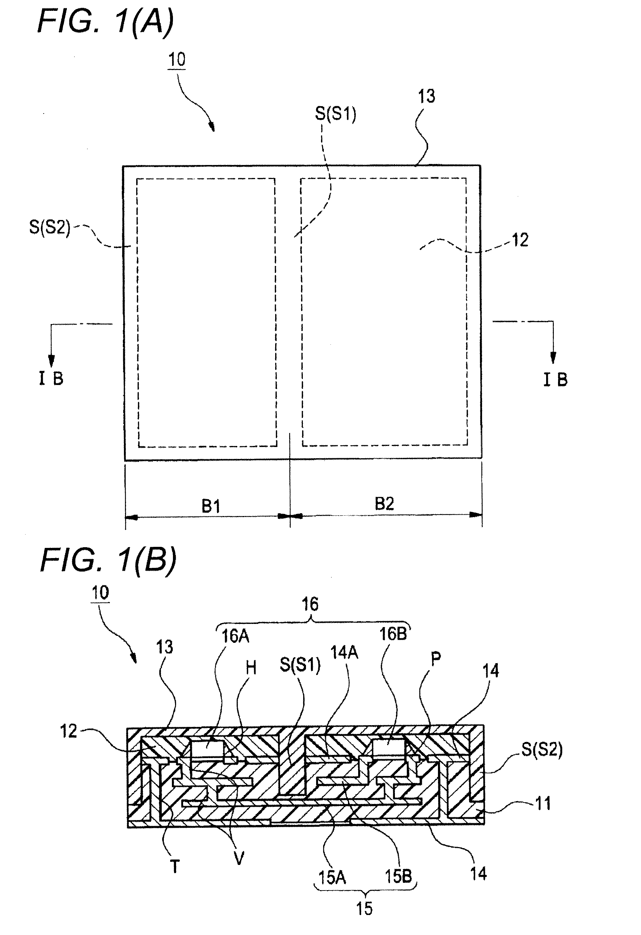

Fig. 1 shows a circuit module 10 to which the invention is applied, and the circuit module 10 is provided inside an electronic device such as a mobile telephone. The circuit module 10 according to a first embodiment of the invention has a thin rectangular parallelepiped shape, and includes a circuit board 11, a molding resin layer 12, a conductive resin layer (shielding layer) 13, a ground line 14, a signal line 15, and plural (two, in the embodiment) electronic components 16.

The circuit board 11 is formed of a proper insulating material such as glass, ceramics or an epoxy resin in substantially a thin plate shape (front and back surfaces are rectangular). The circuit board 11 of the embodiment includes two blocks (a first block B1 and a second block B2) separated in a right and left direction as shown in Fig. 1. On a front surface of the circuit board 11, at least one electronic component 16 described later is mounted in each of blocks B1, B2. Also, pads (forming a part of the signal line) P for mounting the electronic components 16 and forming a part of the pattern wiring together with the ground line 14 are formed on the front surface of the circuit board 11 in each of blocks B1, B2.

The molding resin layer 12 is a resin layer for resin-sealing the circuit board 11 and the electronic components 16, and is particularly hardened in a state in which each of the electronic components 16 mounted on an upper surface (hereinafter called a "front surface") of the circuit board 11 is covered with a proper resin material and is buried. As in the related-art case, the circuit board 11 provided with the molding resin layer 12 can prevent the electronic component 16 from damage even when an external force having a certain degree acts mechanically, and can also exert a stable operation by avoiding adhesion of moisture, dust, etc.

The conductive resin layer 13 is formed on the molding resin layer 12 using a conductive resin made of a proper resin material, etc. This conductive resin layer 13 protects the inner electronic component 16 by shielding against electromagnetic waves from the outside and static electricity, etc. from the adjacent electronic component 16, and also shields against static electricity, etc. generated by the inner electronic component 16 and propagated to the adjacent electronic component 16.

In the conductive resin layer 13 of the embodiment, a slit S is formed between two electronic components 16A, 16B and in an outer edge part of the circuit board 11. The slit S penetrates the molding resin layer 12 and the ground line 14, and is formed to have a depth so as to reach the front surface of the circuit board 11, that is, to reach the inside, and the conductive resin is filled inside the slit S. In the embodiment, the slit S fully penetrates the ground line 14, but it is not essential to fully penetrate the ground line 14 in the invention. Since the minimum requirement of the invention is to achieve bonding between the conductive resin and the ground line 14 formed on the front surface of the circuit board, it is not essential in the invention for the slit S to penetrate the ground line 14 and further reach the inside of the circuit board 11.

That is, the slit S includes an inner slit S1 formed inside the circuit module 10 in plan view, and an outer edge slit S2 formed in an outer edge of the circuit module. The inner slit S1 protects the inner electronic component 16 by shielding against electromagnetic waves from the outside and also electrostatically protects the other of the mutually adjacent electronic components 16 by electrostatically shielding the adjacent electronic components 16. The outer edge slit S2 protects the inner electronic component 16 by shielding against electromagnetic waves from the outside. Depending on a kind of an electronic component mounted, there is an electronic component in which an influence of electromagnetic waves particularly is negligibly small. Therefore, it is unnecessary to place the outer edge slit S2 with respect to this kind of electronic component.

The ground lines 14 are formed on the front surface (a first surface) of the circuit board 11 and a back surface (a second surface) opposite to this front surface, and the ground lines 14 of the front surface and the back surface are mutually electrically connected through a through hole T. In addition, the ground line 14 of the front surface forms pattern wiring in a state of also including the pads P for mounting the electronic components 16.

The signal line 15 includes a first signal line 15A which connects the two electronic components 16, and a second signal line 15B which does not connects the two electronic components 16 as shown in Fig. 1(B). Also, the first signal line 15A and the two electronic components 16 are electrically connected through via holes V. Also, each of the first signal line and the second signal line is arranged in substantially parallel with the front surface or the back surface of the circuit board 11.

The electronic components 16 are mounted on the front surface of the circuit board 11 in the first and second blocks B1, B2, respectively. In the case of the embodiment, semiconductor chip components which are preferably electromagnetically shielded or electrostatically shielded are used for the electronic components 16. In addition, the electronic component 16 using this semiconductor chip is connected to the pad P formed on the front surface of the circuit board 11 by welding using, for example, solder H (or, for example, by wire bonding using a gold wire (Au)).

The first signal line 15A is arranged between the slit and the back surface. And, the first signal line 15A is arranged with an insulating material sandwiched between the slit and the first signal line 15A. Also, the first signal line 15A is formed on a side far from the conductive resin layer 13. For example, in the case of assuming an equidistant surface in the circuit board 11 with the same distance from the front surface and the back surface, the first signal line 15A can be arranged closer to the back surface than this equidistant surface. Since accuracy of depth in cutting of the slit by dicing is relatively low, particularly the inner slit S1 may become deep. Hence, the first signal line 15A which is a signal line extending between the two blocks B1, B2 in which the electronic components 16A, 16B are respectively mounted is formed at a position deeper than the second signal line 15B described later so as to have a margin for responding to variations in the cutting depth of the slit at the time of dicing.

On the other hand, the second signal line 15B is arranged in the circuit board 11 on the front surface side from the first signal line 15A. That is, the second signal line 15B is formed closer to the conductive resin layer 13 than the first signal line 15A in the circuit board 11. Consequently, this second signal line 15B is not configured to extend and striding between the blocks B1, B2 in which the electronic components 16A, 16B are respectively mounted, and an end face of the second signal line 15B opposes the inner slit with an insulating material sandwiched between the inner slit and the end face and is not exposed to the inner slit. In other words, the second signal line 15B is not cut by particularly the inner slit S1, so that the second signal line 15B can be formed in a shallow place. Also, even when variations in the slit depth occur at the time of dicing by the depth of the second signal line, the present circuit module can be manufactured. Consequently, accuracy at the time of dicing is not required excessively, so that the dicing can be performed at low cost, and the circuit module itself can also be manufactured at low cost.

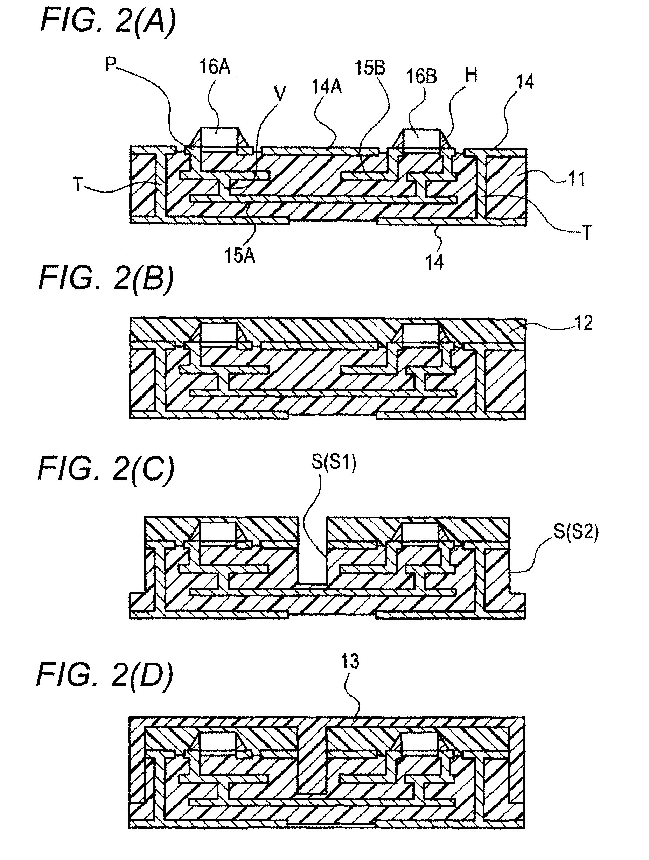

Next, a manufacturing method of the circuit module 10 of the embodiment will be described with reference to Fig. 2. In addition, in manufacture of the circuit module 10 of the embodiment, a circuit board in which the signal line 15 is formed in an inner layer portion and also pattern wiring including the pad P and the ground lines 14 on both the front and back surfaces of the circuit board 11 is formed is used as the circuit board 11.

(1) First, as shown in Fig. 2(A), the electronic component 16 is placed on each of the pads P of the first and second blocks B1, B2 and is electrically connected to the circuit board 11 (a mounting process).
(2) Thereafter, as shown in Fig. 2(B), the molding resin layer 12 formed of a proper resin material is formed on the whole front surface of the circuit board 11 so as to cover all the electronic components 16 and is integrally laminated and hardened (a molding layer formation process).
(3) Next, as shown in Fig. 2(C), at the boundary between the first and second blocks B1, B2, the inner slit S1 is formed up to a predetermined depth by dicing, for example, using a whetstone called a blade (a slit formation process). Also, the outer edge slit S2 which is a groove is formed up to a depth substantially equal to the inner slit S1 by dicing over an outer edge part of the circuit board 11, particularly in the embodiment, over all the outer edge part, i.e., all the four outer sides of the rectangular circuit board 11. In addition, the depth of the inner slit S1 by this dicing may have some variations, but is a depth in which the inner slit S1 can penetrate the molding resin layer 12 and the ground line 14A and also is a depth in which the first signal line 15A is not reached.
(4) Finally, a conductive resin for forming the conductive resin layer 13 is applied until the front surface becomes a flat surface from above the molding resin layer 12 of the circuit board 11 while being filled in the grooves which are the inner slit S1 and the outer edge slit S2. Also, a conductive resin is applied to all the outer edge part of the circuit board 11, whereby a vertical plane perpendicular to the front surface of the circuit board 11 is formed. Thereafter, by a proper process of ultraviolet irradiation etc., the conductive resin is hardened, and the conductive resin layer 13 is formed (a conductive resin layer formation process).

With the above, a series of work processes of manufacturing the circuit module 10 ends.

According to the embodiment, the inner slit S1 is formed at the boundary between the first and second blocks B1, B2, so that the electronic component 16 of each of the blocks can be individually shielded. Also, the conductive resin layer 13 thinner than a metal plate is formed as shielding means, and it becomes unnecessary to cover the shielding means with a conventional metallic frame or cap, so that the board is thinned and thus the circuit module 10 can respond to the thinning requirement.

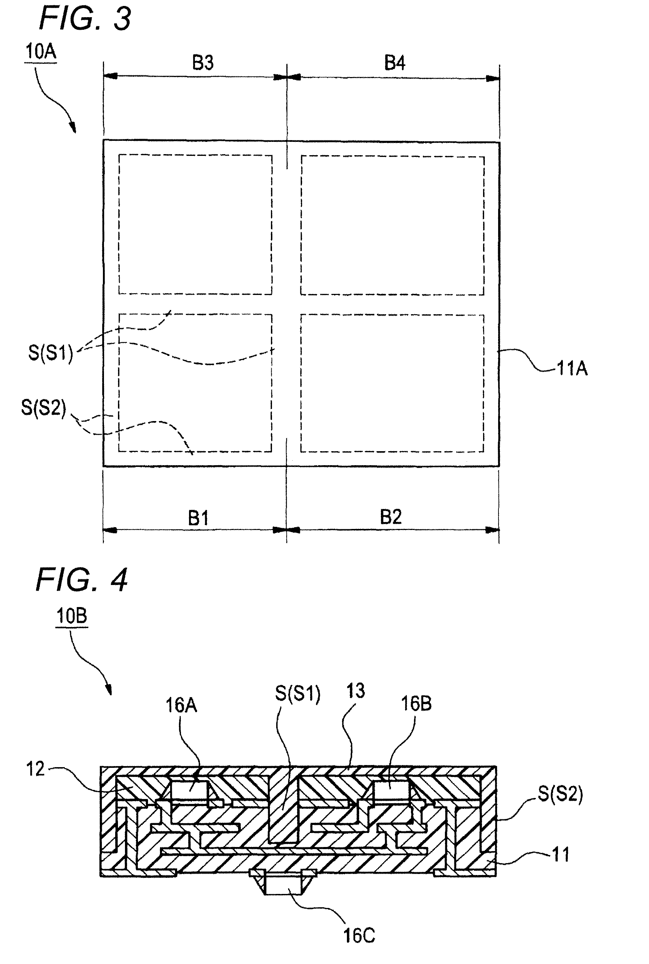

Although the circuit board 11 divided into the two blocks is used as the circuit module 10 in the embodiment, for example, a circuit board 11A which is divided into four blocks B1 to B4 (which may be divided into three blocks or five or more blocks) as shown in Fig. 3 may be used.

That is, each of the blocks B1 to B4 is configured to have two outer edge slits S2 formed in an outer edge of a circuit module 10, and two inner slits S1 formed inside the circuit module 10A in plan view. In other words, each of the blocks B1 to B4 is formed of closed space in which all the periphery is surrounded by the conductive resin layer 13 by the two outer edge slits S2 and the two inner slits S1 filled with the conductive resin. Since shielding properties are improved in the closed space, it is particularly useful in the case of using an electronic component susceptible to electromagnetic waves from outside.

Also, in the embodiment, as the circuit module 10, the electronic components 16A, 16B are mounted on only the upper surface of the circuit board 11. However, as shown in Fig. 4, a circuit module 10B on which an electronic component 16C is mounted on a lower surface may be used.

### (Second embodiment)

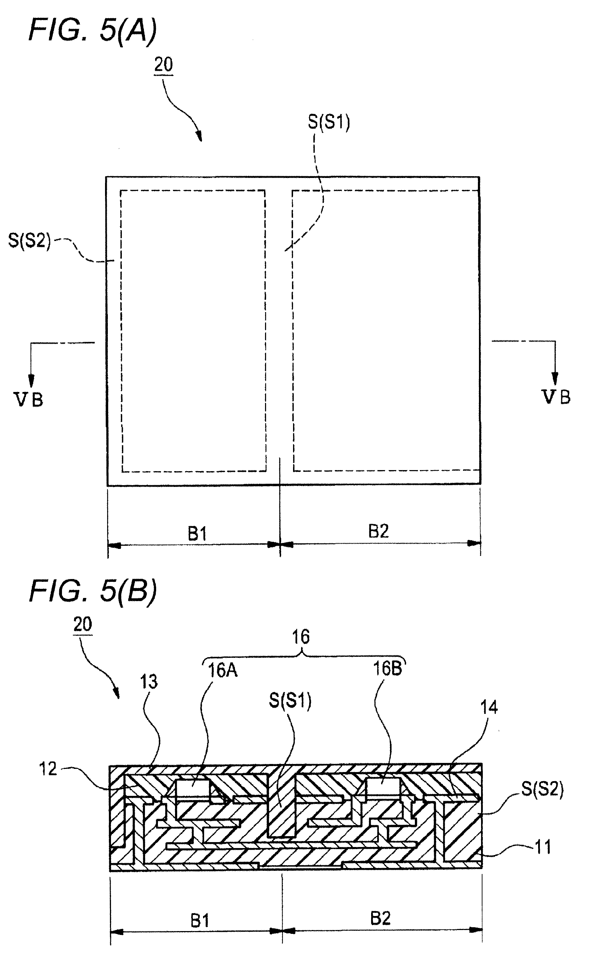

Fig. 5 shows a circuit module 20 according to a second embodiment of the invention. The circuit module 20 differs from the circuit module 10 of the first embodiment in that an electronic component 16D with a small need for shielding against electromagnetic waves from the outside is used as an electronic component 16 mounted in a second block B2 and in that outer edge slits S2 are formed in three outer sides rather than being formed in all the four outer sides (all the outer edge parts).

In a first block B1, arrangement, a configuration, etc. of a conductive resin layer 13 and an electronic component 16A mounted have a configuration similar to that in the first embodiment. On the other hand, in the second block B2, shielding measures against electromagnetic waves from the outside are not taken. This is because an electronic component less susceptible to electromagnetic waves, i.e., an electronic component (which may be any kind of electronic component) in which measures against noise are taken in the component alone is used for the electronic component 16D mounted.

Therefore, according to the embodiment, it is configured to reduce the number of the outer edge slits S2 by one, so that it is easy to perform manufacturing work and is possible to reduce cost.

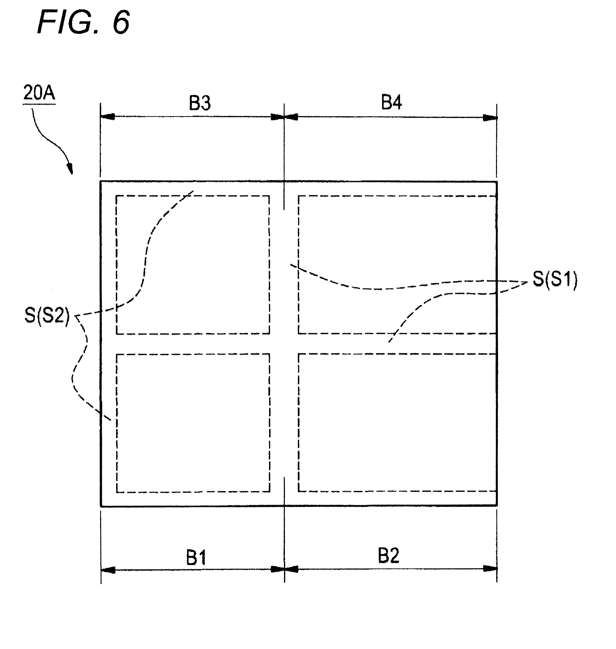

In addition, in the embodiment, the circuit module 20 in which a circuit board 11 is made of the two blocks is described, but the invention is not particularly limited to this. For example, as shown in Fig. 6, when electronic components with no need for electromagnetic shielding are mounted in a circuit module 20A including a circuit board 11 containing four blocks, it is unnecessary to form outer edge slits S2 in the blocks (second and fourth blocks B2, B4, in Fig. 6). Furthermore, in the invention, similar the case described with reference to Fig. 4 as a modification of the first embodiment, an electronic component may further be mounted on a back surface of the circuit board 11 also in the circuit modules 20, 20A of the second embodiment.

In addition, the invention is not limited to the embodiments described above, and the invention is intended to make change and application by persons skilled in the art based on well-known techniques and the mention of the description, and the change and application are included in the scope of protection.

The present application is based on Japanese patent application (patent application No. 2009-068022) filed on March 19, 2009, and the contents of which are hereby incorporated by reference.

### Industrial Applicability

In the invention, blocks divided for respective electronic components mounted on a circuit board of a circuit module are set, and a slit is formed between the blocks and is provided with a conductive resin layer. Therefore, the electronic components are individually shielded. Also, since the conductive resin layer is generally thinner than a metal plate, it is possible to respond to the thinning requirement. Therefore, the invention is useful for thin electronic devices such as a mobile telephone, a PHS (Personal Handy-phone System) or a PDA (Personal Digital Assistant).

### Description of Reference Signs

10, 10B, 20, 20A CIRCUIT MODULE
11 CIRCUIT BOARD
12 MOLDING RESIN LAYER
13 CONDUCTIVE RESIN LAYER
14 GROUND LINE
14A GROUND LINE
15 SIGNAL LINE
15A FIRST SIGNAL LINE
15B SECOND SIGNAL LINE
16,16A,16B,16C ELECTRONIC COMPONENT
B1-B4 BLOCK
H SOLDER
P PAD (PART OF SIGNAL LINE)
S SLIT
S1 INNER SLIT
S2 OUTER EDGE SLIT
T THROUGH HOLE
V VIA HOLE

## Claims

1. A circuit module comprising:
a circuit board having a first surface and a second surface opposite to the first surface;
two or more electronic components mounted on the first surface;
a molding resin layer which seals the first surface and the electronic components; and
a conductive resin layer formed by a conductive resin on the molding resin layer,
wherein a slit penetrating the molding resin layer and reaching the first surface is formed between the two electronic components, and the conductive resin is filled inside the slit.

2. The circuit module according to claim 1, comprising:
a first signal line which connects the two electronic components,
wherein the first signal line is arranged between the slit and the second surface and is arranged with an insulating material sandwiched between the slit and the first signal line.

3. The circuit module according to claim 2, comprising:
a second signal line arranged in the circuit board closer to the first surface than the first signal line,
wherein an end face of the second signal line opposes the slit with an insulating material sandwiched between the slit and the end face.

4. The circuit module according to any one of claims 1 to 3,
wherein the slit comprises: two outer edge slits formed in two outer sides of the circuit module; and two inner slits formed inside the circuit module in plan view, and
wherein closed space surrounded by the conductive resin layer is formed by the two outer edge slits and the two inner slits filled with the conductive resin.

5. An electronic device comprising the circuit module according to any one of claims 1 to 4.

## Amended claims

### Amended claims under Art. 19.1 PCT

**1.** A circuit module comprising:
a board having a first surface and a second surface opposite to the first surface and formed of an insulating material;
first and second electronic components mounted on the first surface;
a molding resin layer which seals the first surface and the first and second electronic components;
a conductive resin layer formed by a conductive resin on the molding resin layer;
a slit which is formed between the first electronic component and the second electronic component, which penetrates the molding resin layer and reaches the first surface, and which is filled with the conductive resin;
a first signal line which is arranged between the first surface and the second surface and which connects the first electronic component and the second electronic component; and
a second signal line which is arranged closer to the first surface than the first electronic component between the first surface and the second surface,
wherein an end face of the second signal line opposes the slit with the insulating material sandwiched therebetween.

**2.** The circuit module according to claim 1,
wherein the slit penetrates the first surface but does not reach the first signal line.

**3.** The circuit module according to claim 2, comprising:
a ground layer arranged on the first surface,
wherein the slit penetrates the ground layer.

**4.** The circuit module according to any one of claims 1 to 3,
wherein the slit comprises:
first and second inner slits which intersect each other;
a first outer edge slit which is formed in a first outer side and which is filled with the conductive resin; and
a second outer edge slit which is formed in a second outer side adjacent to the first outer side and which is filled with the conductive resin.

**5.** The circuit module according to claim 4,
wherein closed space is formed by the board, the conductive resin layer, the conductive resin filled in the first inner slit, the conductive resin filled in the second inner slit, the conductive resin filled in the first outer edge slit, and the conductive resin filled in the second outer edge slit.

**6.** An electronic device comprising the circuit module according to any one of claims 1 to 5.
